# EUROPÄISCHE PATENTSCHRIFT

(11) **EP 0 961 372 B1**
(45) Veröffentlichungstag und Bekanntmachung des Hinweises auf die Patenterteilung: **10.07.2002**
(21) Anmeldenummer: 99109118.2
(22) Anmeldetag: 07.05.1999
(51) Int. Cl.: H01S 5/042, H01S 5/022, H01L 33/00

(54) **Hochfrequenz-Lasermodul und Verfahren zur Herstellung desselben**
High-frequency laser module and method for making the same
Module laser à haute-fréquence et son procédé de fabrication

(30) Priorität: 26.05.1998 DE 19823479
(43) Veröffentlichungstag der Anmeldung: 01.12.1999
(73) Patentinhaber: Infineon Technologies AG, 80506 München (DE)
(72) Erfinder: Auracher, Franz Dr., 82065 Baierbrunn (DE); Althaus, Hans-Ludwig Dr., 93138 Lappersdorf (DE)
(74) Vertreter: Müller, Wolfram Hubertus, Dipl.-Phys.

(56) Entgegenhaltungen:
- WO-A-87/02834
- WO-A-92/13369
- DE-A- 19 700 261
- US-A- 5 602 672
- PATENT ABSTRACTS OF JAPAN vol. 017, no. 253 (E-1367), 19. Mai 1993 (1993-05-19) -& JP 04 373155 A (NIPPON TELEGR & TELEPH CORP), 25. Dezember 1992 (1992-12-25)
- PATENT ABSTRACTS OF JAPAN vol. 017, no. 466 (E-1421), 25. August 1993 (1993-08-25) -& JP 05 110201 A (NEC CORP), 30. April 1993 (1993-04-30)
- PATENT ABSTRACTS OF JAPAN vol. 015, no. 026 (E-1025), 22. Januar 1991 (1991-01-22) -& JP 02 271585 A (MITSUBISHI ELECTRIC CORP), 6. November 1990 (1990-11-06)
- PATENT ABSTRACTS OF JAPAN vol. 018, no. 416 (E-1588), 4. August 1994 (1994-08-04) -& JP 06 125136 A (MITSUBISHI ELECTRIC CORP), 6. Mai 1994 (1994-05-06)
- PATENT ABSTRACTS OF JAPAN vol. 098, no. 001, 30. Januar 1998 (1998-01-30) -& JP 09 252164 A (MITSUBISHI ELECTRIC CORP), 22. September 1997 (1997-09-22)

## Beschreibung

Die Erfindung betrifft Hochfrequenz-Lasermodule gemäß den Oberbegriffen der Ansprüche 1 und 3, ein optoelektronisches Bauelement, das ein derartiges, in einem Gehäuse aufgenommenes Hochfrequenz-Lasermodul aufweist sowie ein Verfahren zur Herstellung einer Vielzahl von Hochfrequenz-Lasermodulen auf einer Halbleiterscheibe gemäß dem Oberbegriff des Anspruchs 10.

Lasermodule sowie auf diesen Lasermodulen basierende optoelektronische Bauelemente sind bereits bekannt und beispielsweise in der europäischen Patentanmeldung EP 0 660 467 A1 und dem US-Patent 5,566,265 beschrieben. Aus der EP 0 660 467 A1 ist ferner ein Verfahren bekannt, mittels dem eine Vielzahl von optoelektronischen Lasermodulen auf einer gemeinsamen Siliziumscheibe hergestellt werden können.

Derartige optoelektronische Bauelemente kommen insbesondere in der Datenübertragungs- und Nachrichtentechnik in weitem Umfang zum Einsatz. Um eine möglichst große Informationsmenge pro Zeiteinheit übertragen zu können, werden die Bauelemente üblicherweise im Hochfrequenzbereich betrieben. Die maximal erreichbare Datenrate des Bauelements ist dabei nicht nur von dem verwendeten Halbleiterlaser bestimmt, sondern hängt von einer Vielzahl weiterer elektrischer, optischer und baulicher Maßnahmen des gesamten optoelektronischen Bauelements einschließlich des verwendeten Gehäuses ab.

In einer Reihe von Patentanmeldungen WO 92 13369, JP 04 373155, JP 05 110201, JP 02 271585 und JP 06 125136 ist offenbart, daß der HF-Anpassungswiderstands R_{A} in unmittelbarer Nähe zum Halbleiterlaser angeordnet ist. Dies gewährleistet eine besonders wirkungsvolle und störungsfreie Anpassung des üblicherweise niederohmigen Halbleiterlasers (typischerweise 3 bis 5 Ohm) an die Impedanz einer Treiberschaltung (üblicherweise 25 oder 50 Ohm), wodurch die Hochfrequenz-Eigenschaften des Lasermoduls deutlich verbessert werden.

Bei den bekannten HF-Lasermodulen mit unmittelbar auf den Trägern der Halbleiterlaser angeordneten Anpassungswiderständen R_{A} würde jedoch eine sogenannte "burn-in"-Prozedur (die mehrtägige Beaufschlagung des Halbleiterlasers mit einem hohen Strom zur Funktionsprüfung und Voralterung) zu einer thermischen Überlastung der Anpassungswiderstände R_{A} führen.

Der Erfindung liegt zum einen Teil die Aufgabe zugrunde, ein Hochfrequenz-Lasermodul mit einem HF-Anpassungswiderstand R_{A} zu schaffen, das gemeinsam mit einer Mehrzahl weiterer Hochfrequenz-Lasermodule auf einem gemeinsamen Substrat herstellbar ist, wobei sich die zugehörigen Halbleiterlaser gemeinsam testen bzw. voraltern lassen, ohne daß dabei eine Überhitzung der HF-Anpassungswiderstande auftreten kann. Ein weiterer Teil der der Erfindung zugrundeliegenden Aufgabe besteht darin, ein optoelektronisches Bauelement mit einem das erfindungsgemäße Hochfrequenz-Lasermodul aufnehmenden Gehäuse zu schaffen, welches speziell für Hochfrequenz-Anwendungen ausgelegt ist. Ferner zielt die Erfindung darauf ab, ein besonders rationelles und kostengünstiges Verfahren zur Herstellung von derartigen Hochfrequenz-Lasermodulen auf einer Halbleiterscheibe anzugeben.

Diese Aufgaben werden erfindungsgemäß durch Hochfrequenz-Lasermodule gemäß den Ansprüchen 1 und 3, ein optoelektronisches Bauelement gemäß Anspruch 5 und ein Verfahren zur Herstellung einer Vielzahl von Hochfrequenz-Lasermodulen gemäß Anspruch 10 gelöst.

Wenn auf dem Träger gemäß Anspruch 1 eine elektrische Nebenleitstrecke vorgesehen ist, die unter Umgehung des HF-Anpassungswiderstands zu dem HF-Anschluß des Halbleiterlasers geführt ist, ergibt dies eine auf dem Träger aufgebrachte Leiterbahnstruktur, die insbesondere dann vorteilhaft ist, wenn das Hochfrequenz-Lasermodul gemäß dem in Anspruch 11 definierten Verfahren zur Herstellung einer Vielzahl von Hochfrequenz-Lasermodulen im Waferverbund hergestellt wird.

Durch die Umgehung des HF-Anpassungswiderstandes mittels der Nebenleitstrecke lassen sich die Halbleiterlaser der auf einer gemeinsamen Halbleiterscheibe hergestellten HF-Lasermodule gemeinsam mit einem hohen Test- bzw. Voralterungsstrom beaufschlagen, wobei die HF-Anpassungswiderstände stromlos und somit unbeansprucht bleiben.

Das von dem Halbleiterlaser erzeugte Licht kann in an sich bekannter Weise einen Elektroabsorptionsmodulator (EAM) durchlaufen und von diesem HF-moduliert werden. Dazu ist der der EAM ebenfalls auf dem Träger angeordnet und ein auf dem Träger vorgesehenes HF-Anschlußpad und ein auf dem Träger vorgesehenes Massekontaktpad des EAMs sind über eine auf dem Träger verlaufende, einen HF-Anpassungswiderstand RA umfassende HF-Leitstrecke verbunden. Da der EAM in Sperrichtung betrieben wird, d.h. im wesentlichen eine kleine Kapazität darstellt, wird zur'Anpassung ein zum EAM parallel geschalteter Anpassungswiderstand verwendet. Durch die gemeinsame Anordnung von Halbleiterlaser und EAM auf demselben Träger wird ein besonders kompakter, für HF-Anwendungen günstiger Gesamtaufbau erzielt, der zudem fertigungstechnisch auf einfache Weise zu realisieren ist. Da der HF-Anpassungswiderstand innerhalb einer auf dem Träger verlaufenden HF-Leitstrecke ausgebildet ist, befindet er sich in unmittelbarer Nähe zum EAM, wodurch das HF-Verhalten des EAMs günstig beeinflußt wird.

Nach Anspruch 3 kennzeichnet sich die Erfindung im wesentlichen dadurch, daß ein auf dem Träger vorgesehener elektri scher Kontaktausläufer unter Umgehung des HF-Anpassungswiderstands R_{A} zu dem HF-Anschluß des Halbleiterlasers geführt ist. Dadurch ist es wiederum möglich, die Halbleiterlaser einer Mehrzahl von HF-Lasermodulen im Scheibenverbund mit einem Test- bzw. Voralterungsstrom zu beaufschlagen, ohne daß dabei Strom durch den HF-Anpassungswiderstand R_{A} fließt.

Bei einem Einbau des erfindungsgemäßen HF-Lasermoduls in ein Gehäuse gemäß Anspruch 5 ist auf ein gutes HF-Design der Baugruppe zu achten. Durch die in den Ansprüchen 6 und 7 angegebenen Merkmale wird eine für die Erzielung hoher Datenraten günstige Kontaktierung des HF-Lasermoduls im Gehäuseinneren geschaffen.

Durch eine HF-Abblockung des Vorstrom-Anschlusses des HF-Halbleiterlasers mittels einer geeigneten Drossel (beispielsweise Spule mit Ferritkern) können HF-Lasermodule mit einer Bandbreite von über 5 GHz erzielt werden. Dadurch lassen sich selbst bei ungekühlten optoelektronischen Bauelementen Datenraten von mindestens 3 Gbit/s realisieren.

Ein im Strahlengang des HF-Lasermoduls vorgesehener optischer Isolator kann die HF-Eigenschaften des Lasermoduls verbessern, indem er das Zurückkehren von reflektiertem Laserlicht zu dem Laser weitgehend unterbindet und auf diese Weise etwaige störende Rückkopplungseffekte wesentlich reduziert.

Erfindungsgemäß werden eine Vielzahl von HF-Lasermodulen auf einer gemeinsamen Halbleiterscheibe (Wafer), insbesondere Siliziumscheibe, hergestellt. Dies hat unter anderem den Vorteil, daß aufgrund der guten Handhabbarkeit der Halbleiterscheibe einfache Herstellungs- und Montageabläufe möglich sind. Dabei wird durch das auf der Halbleiterscheibe vorgesehene erfindungsgemäße Leiterbahnmuster ermöglicht, daß eine als solche bereits bekannte und als "burn-in" bezeichnete Funktions- und Lebensdauerprüfung der HF-Lasermodule weiterhin im Scheibenverbund durchführbar ist. Beim "burn-in" wird der Laserchip über eine vorgegebene Zeitdauer, die 48 Stunden und mehr betragen kann, mit einem verhältnismäßig hohen Strom beaufschlagt, wobei die Stabilität wesentlicher Funktionsparameter geprüft und eine Charakterisierung des Laserchips ermittelt wird. Bei den erfindungsgemäßen HF-Lasermodulen mit unmittelbar auf dem Trägern angeordneten Anpassungswiderständen R_{A} würde diese "burn-in"-Prozedur jedoch zu einer thermischen Überlastung der Anpassungswiderstände R_{A} führen. Durch das erfindungsgemäße Leiterbahnmuster mit Nebenleitstrecke wird sichergestellt, daß der beim "burn-in" fließende Strom nicht durch die HF-Anpassungswiderstände R_{A} fließt sondern über die Nebenleitstrecken an diesen vorbeigeleitet wird. Dies ermöglicht es, daß bei der Herstellung der Lasermodule der "burn-in" weiterhin auf rationelle Weise im Waferverbund, d.h. vor der Auftrennung der Halbleiterscheibe in die einzelnen Lasermodule, durchgeführt werden kann.

Weitere bevorzugte Ausgestaltungen der Erfindung sind in den Unteransprüchen angegeben.

Die Erfindung wird nachfolgend in beispielhafter Weise unter Bezugnahme auf die Zeichnung beschrieben; in dieser zeigt:
- Fig. 1a: eine schematische Querschnittansicht eines Lasermoduls nach dem Stand der Technik;
- Fig. 1b: eine perspektivische Darstellung des in Fig. 1a dargestellten Lasermoduls;
- Fig. 2a: eine schematische Schnittansicht eines erfindungsgemäßen HF-Lasermoduls;
- Fig. 2b: das in Fig. 2a dargestellte HF-Lasermodul in Draufsicht;
- Fig. 3a: eine schematische Darstellung von zwei benachbarten Leiterbahnstrukturen in Draufsicht zur Erläuterung des auf der Siliziumscheibe aufgebrachten Leiterbahnmusters;
- Fig. 3b: eine schematische Schnittdarstellung durch die Siliziumscheibe mit darauf angeordneten HF-Lasermodulen;
- Fig. 4: eine schematische Darstellung eines auf einem Träger angeordneten Laserchips mit Halbleiterlaser und integriertem Elektroabsorptionsmodulator;
- Fig. 5a: eine schematische Schnittansicht entlang der Linie I-I in Fig. 4;
- Fig. 5b: eine schematische Schnittansicht entlang der Linie II-II in Fig. 4;
- Fig. 6: ein erstes Ausführungsbeispiel eines optoelektronischen Bauelements mit einem auf dem Gehäuseboden des Bauelements befestigten HF-Lasermodul in Draufsicht;
- Fig. 7: eine schematische Teilschnittdarstellung des Bauelements aus Fig. 6;
- Fig. 8: eine schematische Teilansicht des in den Fig. 6 und 7 gezeigten optoelektronischen Bauelements;
- Fig. 9: ein zweites Ausführungsbeispiel eines optoelektronischen Bauelements mit einem auf einem Kühlelement befestigten HF-Lasermodul in Teilschnittdarstellung; und
- Fig. 10: das optoelektronische Bauelement aus Fig. 9 in Draufsicht.

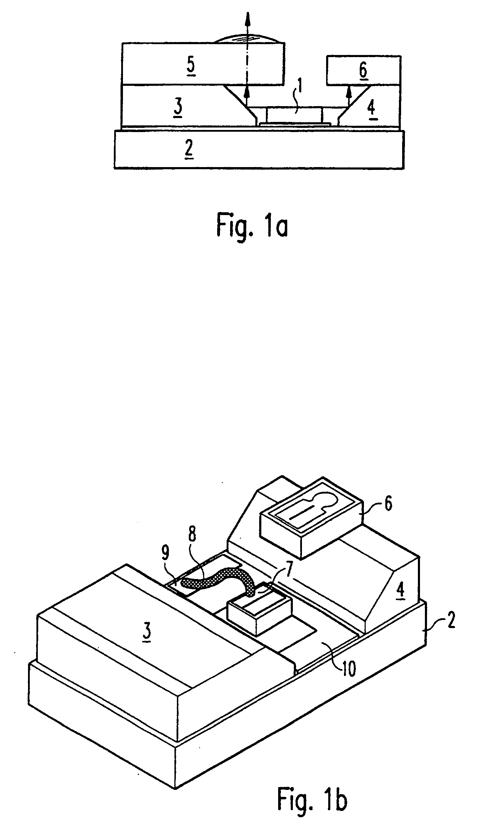

Das in Fig. 1a dargestellte bekannte Lasermodul weist als Lichtsender einen Laserchip 1 auf, der auf einem vorzugsweise aus Silizium bestehenden Träger 2 angeordnet ist. Der Träger 2, der auch als Silizium-Submount bezeichnet wird, trägt ferner zwei Umlenkprismen 3, 4, die zu beiden Seiten des Laserchips 1 angeordnet sind und Spiegelflächen aufweisen, die unter einem Winkel von 45° gegenüber der aktiven Fläche des Laserchips 1 orientiert sind. Auf dem einen Umlenkprisma 3 ist eine Koppellinse 5 aufgebracht und so angeordnet, daß die im Laserchip 1 erzeugte und von dem Umlenkprisma 3 umgelenkte Laserstrahlung die Koppellinse 5 im wesentlichen in Richtung ihrer optischen Achse durchläuft. Hierbei kann der Monitor-Chip 6 auch ohne Umlenkprisma 4 direkt auf dem Träger (Silizium-Submount) 2 befestigt sein.

Auf dem zweiten Umlenkprisma 4 ist ein Monitor-Chip 6 derart angeordnet und befestigt, daß von diesem ein Teil der vom Laserchip 1 erzeugten optischen Strahlung empfangen wird. Der Monitor-Chip 6 kann zur Messung bzw. Regelung der Laserleistung verwendet werden.

Fig. 1b zeigt das in Fig. 1a dargestellte Lasermodul in perspektivischer Ansicht. Aus Gründen der Übersichtlichkeit ist in dieser Figur die Koppellinse 5 weggelassen. Der obenliegende Kontakt 7 des Laserchips 1 ist über einen Bonddraht 8 mit einem randseitig auf dem Träger 2 aufgebrachten Kontaktpad 9 verbunden, während der in Fig. 1b nicht sichtbare untenliegende Kontakt des Laserchips 1 elektrisch kontaktierend auf einem Leiterbahnstreifen 10 aufsteht, der zu dem gegenüberliegenden Rand des Trägers 2 geführt ist und dort eine Kontaktierungsfläche aufweist.

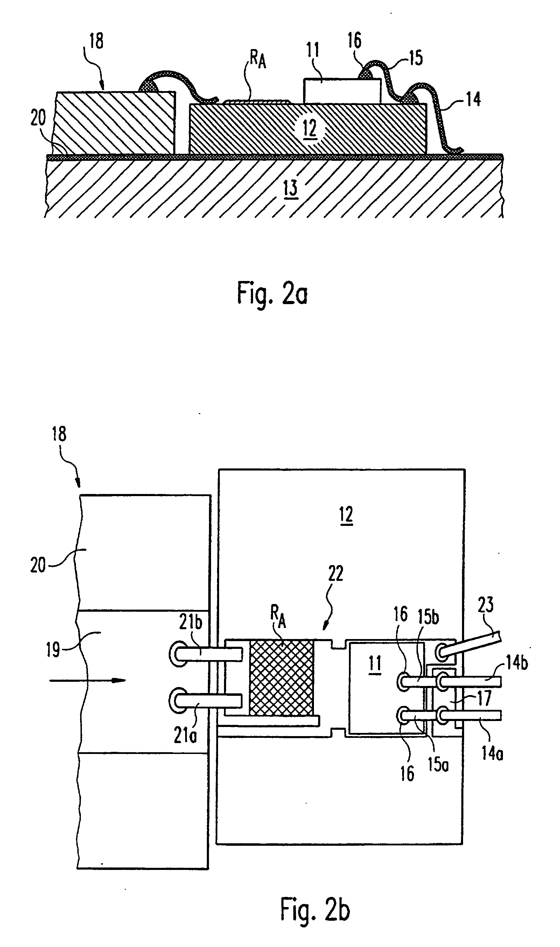

In den Fig. 2a und 2b ist ein Ausführungsbeispiel eines erfindungsgemäßen HF-Lasermoduls für hohe Datenraten dargestellt. Wiederum ist oberhalb eines Halbleiterträgers 12, der vorzugsweise aus Silizium besteht, ein Laserchip 11 angeordnet. Der Träger 12 steht auf einer Gehäusegrundplatte 13 auf, die auf Massepotential liegt und über zwei in Serie geschaltete Bondleitungen 14 und 15 mit dem obenliegenden (zumeist p-) Kontakt 16 des Laserchips 11 in Verbindung steht.

Fig. 2b macht deutlich, daß'sowohl die erste 14 als auch die zweite 15 Bondleitung jeweils aus zwei (oder auch mehr) einzelnen Bonddrähten 14a, 14b bzw. 15a, 15b aufgebaut sein kann, die an einem auf dem Träger 12 angeordneten Massekontaktpad 17 gemeinsam angebondet sind.

Das HF-Datensignal wird über eine geeignete hochfrequenztaugliche Zuleitung in den Bereich des Trägers 12 geführt. Im dargestellten Beispiel wird als Datenzuleitung eine Mikrostreifenleitung 18 verwendet, die im wesentlichen aus einem das Datensignal leitenden Metallstreifen 19 besteht, der oberhalb eines Masseleiters 20 verläuft und gegenüber diesem isoliert geführt ist. Der Masseleiter 20 bildet die Unterseite der Mikrostreifenleitung 18 und ist elektrisch leitend mit einer Massefläche auf der Gehäusegrundplatte 13 verbunden, an der auch die Bonddrähte 14a, 14b angebracht sind. Der Metallstreifen 19 steht über zwei oder in nicht dargestellter Weise auch mehr HF-Bonddrähte 21a, 21b mit dem einen Ende einer auf dem Träger 12 vorgesehenen HF-Leitstrecke 22 in Verbindung, die an ihrem anderen Ende mit einem untenliegenden Kontakt des Laserchips 11 elektrisch verbunden ist. In die HF-Leitstrecke 22 ist erfindungsgemäß ein Anpassungswiderstand R_{A} integriert, der dazu dient, eine möglichst gute Anpassung des niederohmigen Laserchips 11 an den Wellenwiderstand der Mikrostreifenleitung 18 zu erzielen, und im vorliegenden Beispiel einen Wert von 22 Ω aufweist.

Anstelle der in den Fig. 2a und 2b dargestellten Mikrostreifenleitung 18 kann als HF-Zuleitung auch eine koaxiale Leitung oder eine koplanare Leitung mit nebeneinanderliegend angeordneten HF-Leiter- und Massestreifen eingesetzt werden. Der Anpassungswiderstand R_{A} kann vorzugsweise in Abhängigkeit von dem verwendeten HF-Zuleitungstyp und dessen Dimensionierung gewählt werden.

Über die Zuleitung 23 wird dem Laserchip 11 ein Vorstrom (Bias-Strom) zugeführt.

Der untenliegende HF-Anschluß des Laserchips 11 steht ferner mit einer auf dem Träger 12 verlaufenden Nebenleitstrecke 24 in Verbindung, die eine Umgehung des Anpassungswiderstandes R_{A} ermöglicht und für das nachfolgend zu erläuternde Herstellungsverfahren des Hochfrequenz-Lasermoduls im Scheibenverbund von wesentlicher Bedeutung ist.

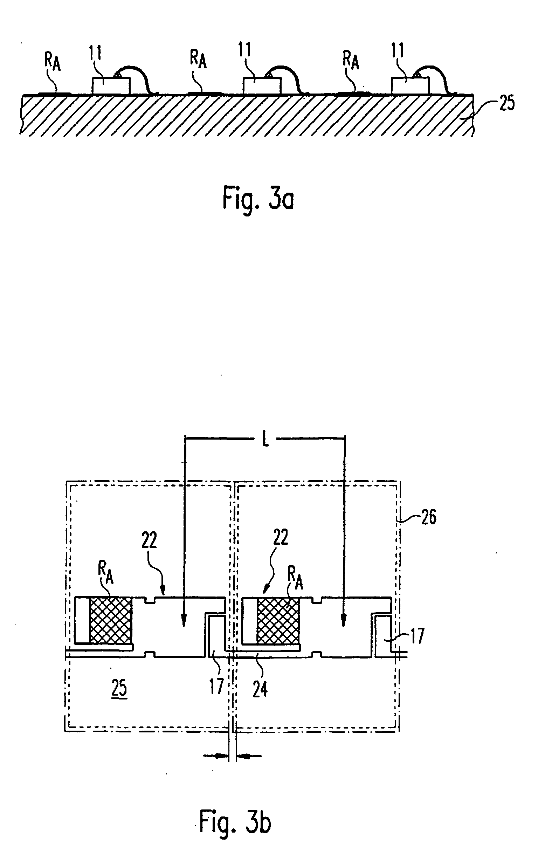

Zur Herstellung der erfindungsgemäßen HF-Lasermodule wird auf einer Siliziumscheibe 25, wie sie in Fig. 3b dargestellt ist, mittels bekannter Techniken zunächst ein Leiterbahnmuster aufgebracht, welches aus periodisch sich wiederholenden Leiterbahnstrukturen aufgebaut ist. Zwei benachbarte Strukturen sind in Fig. 3a dargestellt. Die gestrichelten Linien 26 geben dabei die Konturen der späteren Träger 12 (Silizium-Submounts) wieder. Wesentlich ist, daß bei benachbarten Strukturen eine elektrische Verbindung zwischen dem Massekontaktpad 17 der einen Struktur und der Nebenleitstrecke 24 der anderen Struktur besteht.

Nachfolgend werden die Laserchips 11 durch Löten oder andere übliche Verfahren auf die dafür vorgesehenen Bereiche L der einzelnen Leiterbahnstrukturen montiert. Der Bestückungsvorgang ist in hohem Maße automatisierbar und kann somit auf sehr rationelle Weise durchgeführt werden.

Dann werden in nicht dargestellter Weise Umlenkprismen um die Laserchips 11 herum gruppiert und auf der Siliziumscheibe 25 befestigt, was beispielsweise durch einen weiteren Lötvorgang bewerkstelligt werden kann. Die Anordnung der Umlenkprismen kann entsprechend der Darstellungen in den Fig. 1 und 2 gewählt werden.

Es ist auch möglich, die Umlenkprismen vor der Bestückung der Siliziumscheibe 25 mit den Laserchips 11 in Form von durchgängige Prismenstreifen aufzubringen. Die Prismenstreifen werden dann bei der späteren Vereinzelung der Träger 12 entlang der Trennlinien 26 in einzelne Umlenkprismen zerteilt.

In einem weiteren Schritt des Herstellungsverfahrens werden die auf der Siliziumscheibe 25 montierten Laserchips 11 einer gemeinsamen Funktionsprüfung bzw. Voralterung ("burn-in") unterzogen. Diese Prüfung muß unter Hochstrombedingungen durchgeführt werden, um in vertretbarer Zeit eine Lebensdauerabsicherung der einzelnen Laserchips 11 zu erhalten. Dabei wird der "burn-in"-Strom gemäß dem erfindungsgemäßen Aufbau des Leiterbahnmusters über die Nebenleitstrecken 24 an den Anpassungswiderständen R_{A} vorbeigeführt, so daß diese stromlos bleiben und keinerlei Erwärmung geschweige denn eine Überhitzung dieser Widerstände auftreten kann. Aufgrund dieser Tatsache wird eine Funktionsprüfung der einzelnen Laserchips 11 mit HF-Anpassungswiderstand R_{A} im Scheibenverbund ermöglicht.

Nach der Funktionsprüfung kann die Scheibe in üblicher Weise entlang der Trennlinien 26 in die einzelnen Submounts aufgetrennt werden. Die Submounts können dann einzeln weiterverarbeitet werden und dabei beispielsweise mit einer Linsenkoppeloptik gemäß den Fig. 1 und 2 versehen werden. Ferner können sie mit weiteren, insbesonders für HF-Anwendungen geeigneten optische Bauelementen (z.B. einem optischen Isolator) ausgestattet werden. Es ist jedoch auch möglich, die genannten Weiterverarbeitungsschritte noch vor der Vereinzelung der Submounts, d.h. auf der intakten Siliziumscheibe 25, durchzuführen.

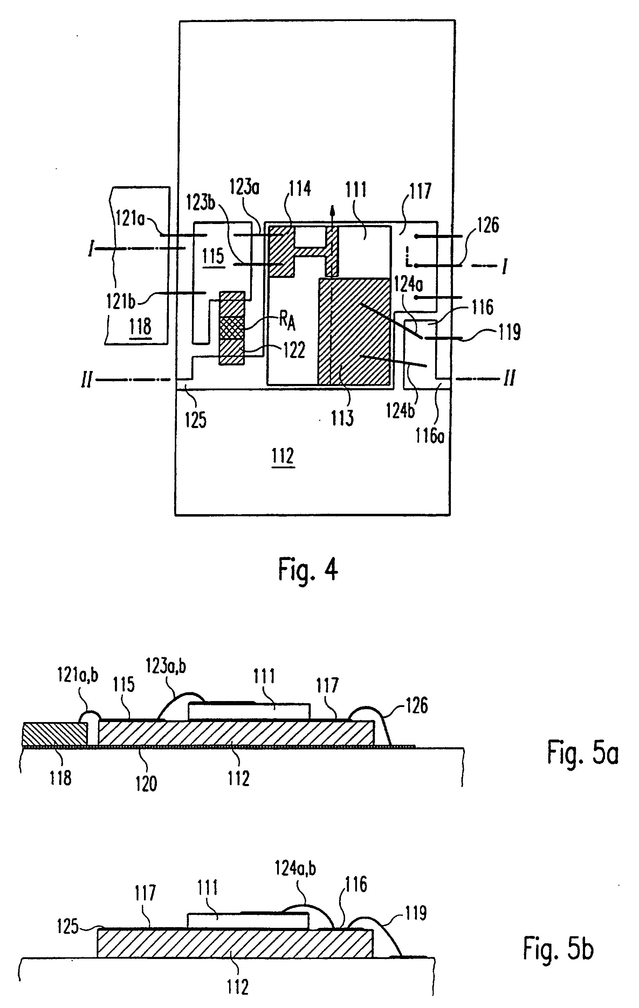

Die Fig. 4 zeigt einen auf einem Träger 112 aufgebrachten Laserchip 111, der einen Halbleiterlaser 113 sowie einen integrierten EAM 114 enthält. Ein HF-Datensignal wird über eine Mikrostreifenleitung 118 und Bonddrähte 121a, 121b zu einem auf dem Träger 112 angeordneten HF-Anschlußpad 115 geführt. Über weitere Bonddrähte 123a, 123b steht das HF-Anschlußpad 115 mit einem HF-Eingang des EAMs 114 in elektrischer Verbindung.

Der Laserchip 111 liegt auf einem Massekontaktpad 117 auf, das einen gemeinsamen Massekontakt für den Halbleiterlaser 113 und den EAM 114 bildet. Ferner ist auf dem Träger 112 ein Bondpad 116 vorgesehen, das über Bondleitungen 124a, 124b mit einem obenliegenden Eingangsanschluß des Halbleiterlasers 113 verbunden ist. Der Halbleiterlaser 113 wird über eine das Bondpad 116 elektrisch kontaktierende Zuleitung 119 mit einem Gleichstrom versorgt, d.h. im Dauerstrichbetrieb betrieben.

Das HF-Anschlußpad 115 ist über einen HF-Anpassungswiderstand R_{A} mit dem Massekontaktpad 117 verbunden. Dieser ist in einer auf dem Träger 112 zwischen dem HF-Anschlußpad 115 und dem Massekontaktpad 117 verlaufenden HF-Leitstrecke 122 ausgebildet und weist typischerweise einen Wert von etwa 50 Ohm auf. Der HF-Anpassungswiderstand R_{A} ist parallel zu dem in Sperrichtung betriebenen EAM 114 geschaltet. Aufgrund seiner Ausbildung auf dem Träger 112 in unmittelbarer Nähe zu dem EAM 114 werden die Hochfrequenz-Eigenschaften des Moduls vorteilhaft beeinflußt.

Ferner ist das Massekontaktpad 117 mittels eines Kontaktausläufers 125 an einen Rand des Trägers 112 geführt. Der Kontaktausläufer 125 bildet vor der Vereinzelung der Träger 112 (Submounts) eine elektrische Verbindung zu einem Ansatz 116a des Bondpads 116 einer benachbarten Leiterbahnstruktur und ermöglicht somit den "burn-in" im Scheibenverbund.

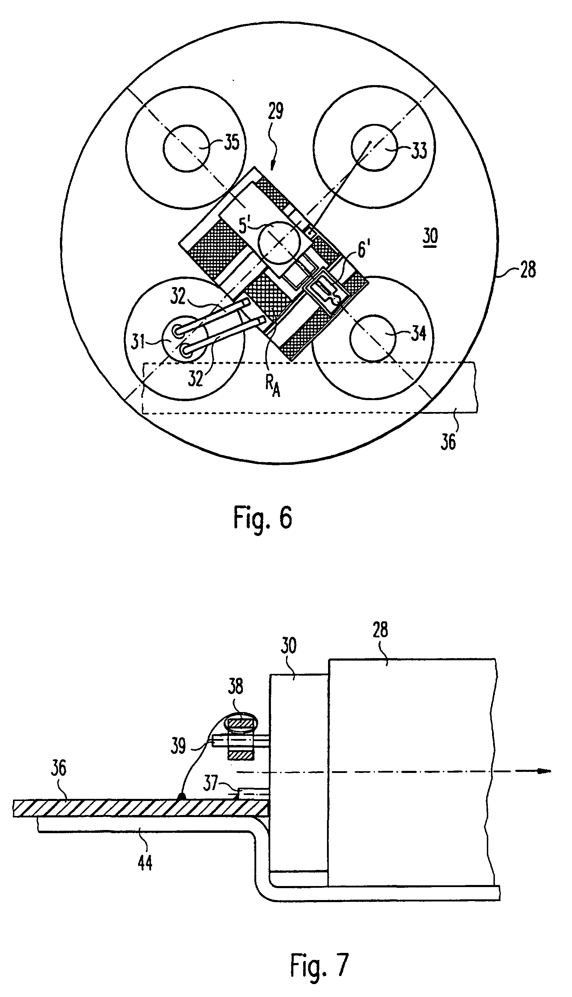

Fig. 5a zeigt einen Schnitt durch den Träger 112 mit Laserchip 111 entlang der Linie I-I. Ein die Unterseite des Mikrostreifenleiters 118 bildender Masseleiter 120 ist unterhalb des Trägers 112 fortgesetzt und kontaktiert das Massepad 117 über Massebondleitungen 126. Die entsprechende Ansicht bei einem Schnitt entlang der Linie II ist in Fig. 5b dargestellt.

In den Fig. 6, 7 und 8 ist ein erstes Beispiel für ein optoelektronisches Bauelement dargestellt, das mit einem erfindungsgemäßen HF-Lasermodul 29 gemäß der Figuren 2a bis 5b (d.h. entweder mit oder ohne integriertem EAM) betrieben wird und bei dem darüber hinaus weitere Maßnahmen ergriffen sind, um eine möglichst hohe Datenrate zu erzielen. Fig. 6 zeigt in Draufsicht den Innenaufbau eines Koaxialgehäuses 28 mit Lasermodul 29. Das Koaxialgehäuse 28, das auch als TO-(Transistor-Outline)-Gehäuse bezeichnet wird, weist eine Bodenplatte 30 mit vier elektrischen Durchführungen auf. Das HF-Signal (Datensignal) wird über einen isolierten, beispielsweise eingeglasten Pin 31 in das Gehäuseinnere geführt und dort über kurze Bonddrähte oder Bändchen 32 elektrisch mit dem HF-Anpassungswiderstand R_{A} bzw. bei Verwendung eines in den Fig. 4 und 5a, 5b gezeigten Laserchips 111 mit integriertem EAM 114 mit dem HF-Anschlußpad 115 verbunden. Über einen weiteren Durchführungs-Pin 33 wird das Lasermodul 29 mit Vorstrom versorgt. Die Pins 34 und 35 stellen weitere Durchführungen dar und dienen der elektrischen Kontaktierung des Monitor-Chips 6'. Das Lasermodul 29 kann in dem Koaxialgehäuse 28 so positioniert sein, daß die optische Achse einer Koppellinse 5' mit der Gehäusemittenachse zusammenfällt. Es kann aber auch eine beliebige außermittige optische Achse eingestellt werden. Rückseitig der Bodenplatte 30 des Gehäuses 28 erstreckt sich eine Platine 36, deren Lage in ihrem von dem Gehäuse 28 verdeckten Abschnitt durch eine gestrichelte Linie angedeutet ist.

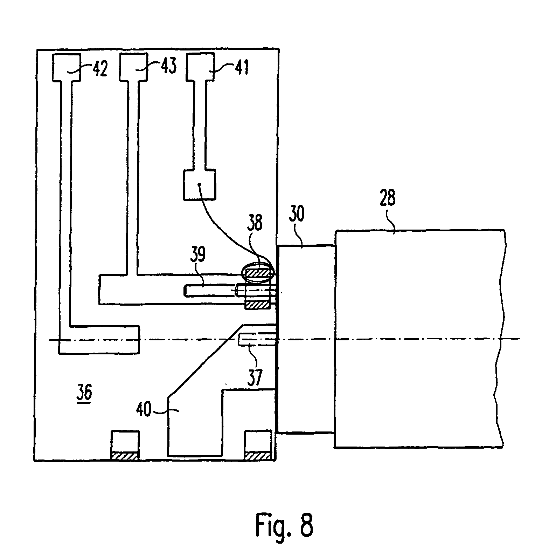

Fig. 7 zeigt das optoelektronische Bauelement aus Fig. 6 in Seitenansicht. Die Platine 36 sowie das Koaxialgehäuse 28 sind an einer Metallasche 44 befestigt, die gleichzeitig als Masseleitung dient. Die HF-Zuführung erfolgt über das aus der Bodenplatte 30 herausstehende Ende 37 des Pins 31. Da die Platine 36 bis an die Rückwand 30 des Gehäuses 28 herangeführt ist und außerdem das Ende 37 des HF-Pins 31 unmittelbar auf der Platine 36 aufliegt und dort mit einer HF-Leiterbahn verlötet oder verschweißt ist (siehe Fig. 8), kann auf Bonddrähte verzichtet werden und es wird eine insgesamt ausgesprochen kurzstreckige elektrische HF-Anbindung geschaffen.

Das Gehäuse 28 kann auch in nicht dargestellter Weise einen Massepin aufweisen, der mit einer Masseseite der Platine 36 verlötet ist . In diesem Fall kann die Metallasche 44 entfallen.

Mittels einer kleinen Ferritspule 38 kann in vorteilhafter Weise eine HF-Abblockung des Vorstrom-Pins 33 erzielt werden. Die Ferritspule 38 besteht aus einer mit mindestens zwei Windungen bewickelten Ferritperle, die über ein gehäuserückseitig vorstehendes Ende 39 des Vorstrom-Pins 33 geschoben ist. Alternativ kann der Vorstrom-Pin 33 auch möglichst kurzstrekkig mit einer auf der Platine befindlichen HF-Drossel verbunden werden. Noch bessere HF-Eigenschaften werden erzielt, wenn die HF-Drossel im Inneren des TO-Gehäuses 28 möglichst nahe am Laserchip angeordnet ist. In dieser Aufbauweise können Module mit einer Bandbreite von mindestens 5 GHz erzielt werden. Bei Verwendung eines in der Fig. 7 nicht dargestellten üblichen optischen Faseranschlusses lassen sich ungekühlte koaxiale Bauelemente für Datenraten von mindestens 3 Gbit/s realisieren. Für größere Übertragungsstrecken ist bei hohen Datenraten (> 1Gbit/s) ein optischer Isolator zwischen Laserdiode und Faser vorzusehen.

Fig. 8 zeigt den in Fig. 7 dargestellten Aufbau in Draufsicht mit den entsprechenden Anschlußleiterbahnen 40, 41 für das HF-Signal bzw. den Vorstrom sowie den weiteren Leiterbahnen 42, 43 zur Kontaktierung des Monitor-Chips 6'.

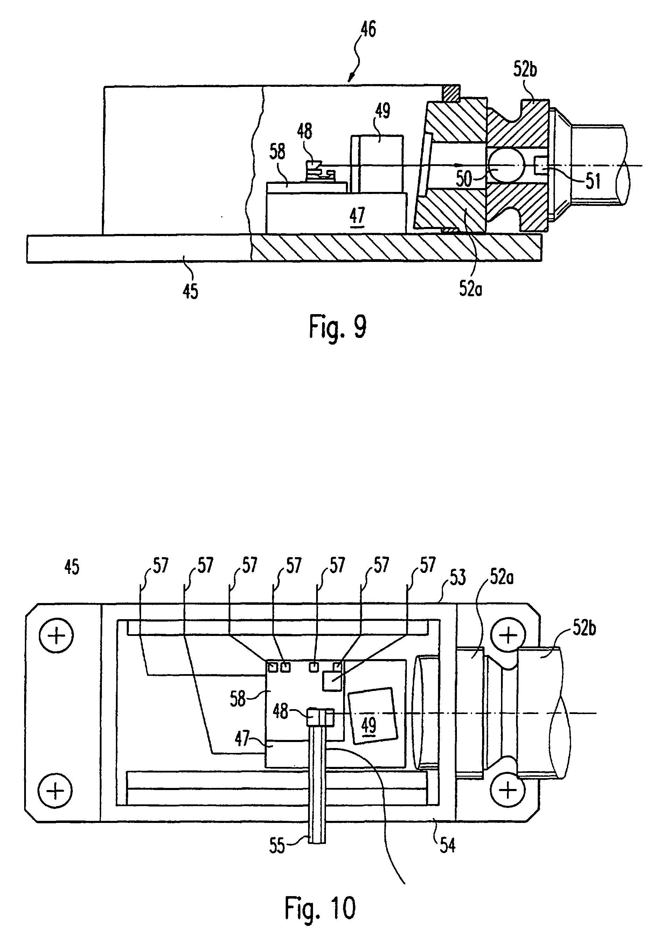

Fig. 9 zeigt ein zweites Ausführungsbeispiel eines optoelektronischen Bauelements nach der Erfindung. Auf einer Bodenplatte 45 eines Metallgehäuses 46 ist ein Kühlelement 47, beispielsweise ein Peltierelement, montiert. Auf dessen Oberfläche ist i.a. ein gut wärmeleitender, aber elektrisch isolierender Zwischenträger 58 z.B. aus BeN oder Si aufgebracht, auf dem sich die erforderlichen Metallisierungen (Massefläche für die Streifenleitung), Kontakte- bzw. Bondpads für die Anschlüsse z.B. des Monitor-Chips, der HF-Drossel und eines Temperaturfühlers befinden und der die Grundfläche für ein HF-Lasermodul 48 bildet. Das HF-Lesermodul 48 ist gemäß den Fig. 2a bis 5b (d. h. mit oder ohne integriertem EAM) ausgeführt und unterscheidet sich von dem in Fig. 7 dargestellten Lasermodul 29 im wesentlichen nur dadurch, daß es im Strahlengang hinter der Koppellinse 5' mit einem weiteren 90°-Umlenkprisma ausgerüstet ist und somit parallel zur Ebene des Trägers (Submounts) gerichtetes Laserlicht abgibt.

In Strahlrichtung hinter dem HF-Lasermodul 48 ist zur Vermeidung von Rückwirkungen durch reflektiertes Licht auf den Laser ein optischer Isolator 49 angeordnet. Der optische Isolator 49 ist über eine gut wärmeleitende Verbindung auf dem Kühlelement 47 befestigt, wodurch ein Einfluß der Umgebungstemperatur auf den optischen Isolator 49 vernachlässigbar gering gehalten werden kann.

Austrittsseitig ist am Gehäuse eine Faserankopplung vorgesehen, die im wesentlichen aus einem gehäuseseitigen Flanschstück 52a und einem die Faser 51 fixierenden Flanschstück 52b mit integrierter Linse 50 besteht.

Fig. 10 zeigt das in Fig. 9 dargestellte Bauelement in Draufsicht. Im Bereich einer Längsseitenwand 53 sind eine Reihe einfacher elektrischer Durchführungen 57 für die Versorgungsund Meßleitungen der in dem Gehäuse aufgenommenen Elemente (beispielsweise Peltierelement, Monitor-Chip usw.) vorgesehen. An der gegenüberliegenden Seitenwand 54 befindet sich eine HF-Durchführung 56, die in Form eines die Wand durchlaufenden Mikrostreifenleiters 55 oder in nicht dargestellter Weise einer koaxialen Leitung in Form eines eingeglasten Pins ausgeführt ist. Die Verbindung zwischen der HF-Durchführung 56 und dem HF-Lasermodul 48 wird durch eine Mikrostreifenoder Koplanarleitung hergestellt, wobei die jeweiligen Masseleitungen durch Schweißen, Löten oder mittels Leitkleber und die Signalleiterbahnen mittels Bonddrähten oder Bändchen verbunden werden.

Beiden Ausführungsbeispielen ist gemeinsam, daß durch die beschriebenen, das HF-Lasermodul 29; 48, das Gehäuse 28; 46 mit elektrischen Durchführungen und die optische Ausrüstung betreffenden Maßnahmen ein einfach aufgebautes, kostengünstiges und für hohe Datenraten geeignetes optisches Bauelement bereitgestellt wird.

## Patentansprüche

1. Hochfrequenz-Lasermodul, das einen Träger (12), einen auf dem Träger (12) angeordneten Halbleiterlaser (11) und eine auf dem Träger (12) vorgesehene elektrische HF-Leitstrecke (22) aufweist, an deren erstes Ende ein externes HF-Treibersignal anlegbar ist und die an ihrem zweiten Ende mit einem HF-Anschluß des Halbleiterlasers (11) elektrisch verbunden ist, wobei die HF-Leitstrecke (22) einen in Serie zu dem Halbleiterlaser (11) geschalteten HF-Anpassungswiderstand R_{A} umfaßt,
**dadurch gekennzeichnet, daß**
eine auf dem Träger (12) vorgesehene elektrische Nebenleitstrecke (24) unter Umgehung des HF-Anpassungswiderstands R_{A} zu dem HF-Anschluß des Halbleiterlasers (11) geführt ist.

2. Hochfrequenz-Lasermodul nach Anspruch 1, **dadurch gekennzeichnet, daß** der HF-Anpassungswiderstand R_{A} zwischen 10 und 50 Ω, insbesondere zwischen 20 und 25 Ω beträgt.

3. Hochfrequenz-Lasermodul, das einen Träger (112), einen auf dem Träger (112) angeordneten Chip (111) mit Halbleiterlaser (113) und Elektroabsorptionsmodulator (114), ein auf dem Träger (112) vorgesehenes HF-Anschlußpad (115) und ferner ein auf dem Träger (112) vorgesehenes, mit dem elektrischen Massekontakt des Elektroabsorptionsmodulators (114) in elektrischem Kontakt stehendes Massekontaktpad (117) umfaßt, wobei auf dem Träger (112) eine das HF-Anschlußpad (115) mit dem Massekontaktpad (117) elektrisch verbindende HF-Leitstrecke (122) vorgesehen ist, die einen zu dem Elektroabsorptionsmodulator (114) parallel geschalteten HF-Anpassungswiderstand R_{A} umfaßt,
**dadurch gekennzeichnet, daß**
ein auf dem Träger (112) vorgesehener elektrischer Kontaktausläufer (125) unter Umgehung des HF-Anpassungswiderstands R_{A} zu dem HF-Anschluß des Halbleiterlasers (113) geführt ist.

4. Hochfrequenz-Lasermodul nach einem der vorhergehenden Ansprüche, **dadurch gekennzeichnet, daß** das Lasermodul (29; 48) eine Linsenkoppeloptik (5') zum definierten Abstrahlen des von dem Halbleiterlaser (11) erzeugten Laserlichts umfaßt.

5. Optoelektronisches Bauelement, das ein HF-Lasermodul (29; 48) nach einem der vorhergehenden Ansprüche sowie ein das HF-Lasermodul (29; 48) aufnehmendes Gehäuse (28; 46) mit einer elektrischen Durchführung für das HF-Treibersignal und einem geeignet angeordneten Lichtaustrittsfenster umfaßt.

6. Optoelektronisches Bauelement nach Anspruch 5, **dadurch gekennzeichnet, daß** die elektrische HF-Durchführung mittels eines durch eine Gehäusewand (30) geführten, elektrisch isolierten Pins (31) erfolgt, dessen außerhalb des Gehäuses (28) liegendes Ende (37) direkt mit einer auf einer Platine (36) angeordneten HF-Leiterbahn (40) elektrisch verbunden, insbesondere verlötet ist.

7. Optoelektronisches Bauelement nach Anspruch 5, **dadurch gekennzeichnet, daß** sowohl die elektrische HF-Durchführung (56) als auch die gehäuseinnenseitige elektrische HF-Verbindung zu dem Lasermodul (48) in Form einer koaxialen Leitung oder einer Mikrostreifenleitung (18, 55) oder einer koplanaren Leitung ausgeführt ist.

8. Optoelektronisches Bauelement nach einem der Ansprüche 5 bis 7, **dadurch gekennzeichnet, daß** innerhalb oder außerhalb des Gehäuses (28; 46) eine Induktivität (38) vorgesehen ist, über die dem Halbleiterlaser (11) ein Vorstrom zugeführt wird.

9. Optoelektronisches Bauelement nach einem der Ansprüche 5 bis 8, **gekennzeichnet durch** einen im Strahlengang des HF-Lasermoduls (29, 48) angeordneten optischen Isolator (49).

10. Verfahren zur Herstellung einer Vielzahl von HF-Lasermodulen auf einer einzelnen Halbleiterscheibe **dadurch gekennzeichnet**,
a)daß auf der Halbleiterscheibe (25) ein Leiterbahnmuster aufgebracht wird, das aus einer sich periodisch wiederholenden Leiterbahnstruktur aufgebaut ist, wobei
- jede einzelne Leiterbahnstruktur zumindest eine HF-Leitstrecke (22) mit einem HF-Anpassungswiderstand R_{A}, eine den HF-Anpassungswiderstand R_{A} umgehende Nebenleitstrecke (24) sowie einen gegenüber der HF-Leitstrecke (22) und der Nebenleitstrecke (24) elektrisch isolierten Massekontaktbereich (17) umfaßt und
- bei benachbarten Leiterbahnstrukturen die Nebenleitstrekke (24) der einen Struktur mit dem Massekontaktbereich (17) der anderen Struktur elektrisch verbunden ist;
b)daß auf jede Struktur ein Halbleiterlaser (11) aufgebracht und elektrisch mit der HF-Leitstrecke (22) und den Massekontaktbereich (17) verbunden wird;
c)daß durch Anlegen eines über die Nebenleitstrecken (24), die Halbleiterlaser (11) und die Massekontaktbereiche (17) fließenden Belastungsstromes eine gemeinsame Funktionsprüfung und/oder Voralterung von mehreren Halbleiterlasern (11) auf der Halbleiterscheibe (25) durchgeführt wird und;
d)daß die Halbleiterscheibe (25) entsprechend dem Leiterbahnmuster in einzelne HF-Lasermodule (29, 48) aufgetrennt wird.

11. Verfahren nach Anspruch 10, **dadurch gekennzeichnet, daß** vor Schritt d) zu jedem Halbleiterlaser (11) eine Linsenkoppeloptik (5') auf die Halbleiterscheibe aufgebracht wird.

12. Verfahren nach Anspruch 11, **dadurch gekennzeichnet, daß** vor Schritt d) eine Justage der Linsenkoppeloptik (5') durchgeführt wird.

## Claims

1. Radio-frequency laser module which has a substrate (12), a semiconductor laser (11) arranged on the substrate (12) and an electrical RF conductive path (22) provided on the substrate to the first end of which path an external RF driver signal can be applied, and which is electrically connected at its second end to an RF connection of the semiconductor laser (11), the RF conductive path (22) comprising an RF matching resistor R_{A} connected in series with the semiconductor laser (11),
**characterized in that**
an electrical secondary conductive path (24) provided on the substrate (12) is connected to the RF connection of the semiconductor laser (11), bypassing the RF matching resistor R_{A}.

2. Radio-frequency laser module according to Claim 1, **characterized in that** the RF matching resistor R_{A} is between 10 and 50 Ω, in particular between 20 and 25 Ω.

3. Radio-frequency laser module which comprises a substrate (112), a chip (111) which is arranged on the substrate (112) and has a semiconductor laser (113) and an electrical absorption modulator (114), an RF connecting pad (115) which is provided on the substrate (112), and, furthermore, an earth contact pad (117) which is provided on the substrate (112) and makes electrical contact with the electrical earth contact of the electrical absorption modulator (114), an RF conductive path (122) being provided on the substrate (112), electrically connects the RF connecting pad (115) to the earth contact pad (117) and comprises an RF matching resistor R_{A} connected in parallel with the electrical absorption modulator (114),
**characterized in that**
an electrical contact spur (125) provided on the substrate (112) is connected to the RF connection of the semiconductor laser (113), bypassing the RF matching resistor R_{A}.

4. Radio-frequency laser module according to one of the preceding claims, **characterized in that** the laser module (29; 48) comprises lens coupling optics (5') for defined emission of the laser light produced by the semiconductor laser (11).

5. Optoelectronic component, which comprises an RF laser module (29; 48) according to one of the preceding claims, as well as a case (28; 46) which accommodates the RF laser module (29; 48) and has an electrical bushing for the RF driver signal and a suitably arranged light outlet window.

6. Optoelectronic component according to Claim 5, **characterized in that** the electrical RF bushing is provided by means of an electrically insulated pin (31) which is passed through a case wall (30) and whose end (37) located outside the case (28) is electrically connected, in particular soldered, directly to an RF interconnect (40) arranged on a board (36).

7. Optoelectronic component according to Claim 5, **characterized in that** both the electrical RF bushing (56) and the electrical RF connection inside the case are designed to form the laser module (48) in the form of a coaxial line or a stripline (18, 55) or a coplanar line.

8. Optoelectronic component according to one of Claims 5 to 7, **characterized in that** an inductance (38) is provided inside or outside the case (28; 46), via which inductance (38) a bias current is supplied to the semiconductor laser (11).

9. Optoelectronic component according to one of Claims 5 to 8, **characterized by** an optical isolator (49) which is arranged in the beam path of the RF laser module (29, 48).

10. Method for producing a large number of RF laser modules on a single semiconductor wafer **characterized**,
a) in that an interconnect pattern is applied on the semiconductor wafer (25), which pattern is formed from a periodically repeating interconnect structure, in which case
- each individual interconnect structure comprises at least one RF conductive path (22) having an RF matching resistor R_{A}, a secondary conductive path (24) surrounding the RF matching resistor R_{A}, and an earth contact region (17) which is electrically insulated from the RF conductive path (22) and the secondary conductive path (24), and
- in adjacent interconnect structures, the secondary conductive path (24) of the one structure is electrically connected to the earth contact region (17) of the other structure;
b) in that a semiconductor laser (11) is applied to each structure and is electrically connected to the RF conductive path (22) and the earth contact region (17);
c) in that a joint functional test and/or pre-aging of a plurality of semiconductor lasers (11) on the semiconductor wafer (25) is carried out by applying a load current flowing via the secondary conductive paths (24), the semiconductor lasers (11) and the earth contact regions (17), and;
d) in that the semiconductor wafer (25) is cut up into individual RF laser modules (29, 48) in accordance with the interconnect pattern.

11. Method according to Claim 10, **characterized in that**, before step d), lens coupling optics (5') are applied to the semiconductor wafer for each semiconductor laser (11).

12. Method according to Claim 11, **characterized in that**, before step d), the lens coupling optics (5') are adjusted.

## Revendications

1. Module laser à haute-fréquence qui comporte un support (12), un laser (11) à semi-conducteur monté sur le support (12) et une section (22) électrique conductrice HF prévue sur le support (12) à la première extrémité de laquelle peut être appliqué un signal extérieur d'attaque HF et qui est relié à sa deuxième extrémité électriquement à une borne HF du laser (11) à semi-conducteur, la section (22) conductrice HF comprenant une résistance R_{A} d'adaptation HF montée en série avec le laser (11) à semi-conducteur,
**caractérisé en ce que**
une section (24) électrique conductrice secondaire prévue sur le support (12) mène en contournant la résistance R_{A} d'adaptation HF à la borne HF du laser (11) à semi-conducteur.

2. Module laser à haute-fréquence suivant la revendication 1, **caractérisé en ce que** la résistance R_{A} d'adaptation HF est comprise entre 10 et 50 Ω, notamment entre 20 et 25 Ω.

3. Module laser à haute-fréquence, qui comporte un support (112) une puce (111) disposée sur le support (112) et ayant un laser (113) à semi-conducteur et un modulateur (114) d'électroabsorption, une plage (115) de connexion HF prévue sur le support (112) et, en outre, une plage (117) de contact électrique de masse prévue sur le support (112) et en contact électrique avec le contact électrique de masse du modulateur (114) d'électroabsorption, et il est prévu sur le support (112) une section (122) conductrice HF reliant électriquement la plage (115) de connexion HF à la plage (117) de contact de masse et comprenant une résistance R_{A} d'adaptation HF montée en parallèle avec le modulateur (114) d'électroabsorption,
**caractérisé en ce qu'**une dérivation (125) électrique de contact prévue sur le support (112) va en contournant la résistance R_{A} d'adaptation HF à la borne HF du laser (113) à semi-conducteur.

4. Module laser à haute-fréquence suivant l'une des revendications précédentes, **caractérisé en ce que** le module laser (29, 48) comprend une optique (5') de couplage à lentille pour émettre de manière définie la lumière laser produite par le laser (11) à semi-conducteur.

5. Composant opto-électronique qui comprend un module laser (29, 48) HF suivant l'une des revendications précédentes ainsi qu'un boîtier (28, 46) recevant le module (29, 48) HF et ayant une traversée électrique pour le signal d'attaque HF et une fenêtre de sortie de la lumière disposée de manière appropriée.

6. Composant opto-électronique suivant la revendication 5, **caractérisé en ce que** la traversée électrique HF a lieu au moyen d'une broche (31) qui passe à travers la paroi (30) du boîtier, qui est isolée électriquement et dont l'extrémité (37) se trouvant à l'extérieur du boîtier (28) est reliée électriquement, en étant notamment soudée, directement à une piste (40) conductrice HF disposée sur une platine (36).

7. Composant opto-électronique suivant la revendication 5, **caractérisé en ce que** tant la traversée (56) électrique HF que la liaison électrique HF du côté intérieur du boîtier et allant au module laser (48) est réalisée sous la forme d'une ligne coaxiale ou d'une ligne (18, 55) à ruban microscopique ou d'une ligne coplanaire.

8. Composant opto-électronique suivant l'une des revendications 5 à 7, **caractérisé en ce qu'**il est prévu à l'intérieur ou à l'extérieur du boîtier (28, 46) une inductance (38) par laquelle il est envoyé un courant de polarisation au laser (11) à semi-conducteur.

9. Composant opto-électronique suivant l'une des revendications 5 à 8, **caractérisé par** un isolateur (49) optique monté dans le trajet du rayonnement du module laser (29, 48) HF.

10. Procédé de fabrication d'une pluralité de modules laser HF sur une seule tranche semi-conductrice, **caractérisé**
a) en ce que l'on dépose sur la tranche (25) semi-conductrice un modèle de piste conductrice qui est constitué d'une structure de piste conductrice se répétant périodiquement,
- chaque structure individuelle de piste conductrice comprenant au moins une section (22) conductrice HF ayant une résistance R_{A} d'adaptation HF, une section (24) conductrice secondaire contournant la résistance R_{A} d'adaptation HF ainsi qu'une zone (17) de contact de masse isolée électriquement par rapport à la section (22) conductrice HF et par rapport à la section (24) conductrice secondaire, et
- dans une structure voisine de piste conductrice, la section (24) conductrice secondaire de l'une des structures est reliée électriquement à la zone (17) de contact de masse de l'autre structure ;
b) en ce que, sur chaque structure, on dépose un laser (11) à semi-conducteur et on le relie électriquement à la section (22) conductrice HF et à la zone (17) de contact de masse ;
c) en ce que, par l'application d'un courant de charge passant par les sections (24) conductrices secondaires, les lasers (11) à semi-conducteurs et les zones (17) de contact de masse, on effectue un essai fonctionnel commun et/ou un pré-vieillissement de plusieurs lasers (11) à semi-conducteur sur la tranche (25) semi-conductrice, et
d) en ce que l'on sépare la tranche (25) semi-conductrice en modules laser (29, 48) HF individuels conformément au modèle de piste conductrice.

11. Procédé suivant la revendication 10, **caractérisé en ce que**, avant le stade d), on dépose pour chaque laser (11) à semi-conducteur une optique (5') de couplage à lentille sur la tranche semi-conductrice.

12. Procédé suivant la revendication 11, **caractérisé en ce que**, avant le stade d), on effectue un ajustage de l'optique (5') de couplage à lentille.
